# EUROPÄISCHE PATENTSCHRIFT

(11) **EP 0 555 669 B1**
(45) Veröffentlichungstag und Bekanntmachung des Hinweises auf die Patenterteilung: **29.11.1995**
(21) Anmeldenummer: 93100863.5
(22) Anmeldetag: 21.01.1993
(51) Int. Cl.: B41F 15/20

(54) **Siebdruckvorrichtung**
Screen printing apparatus
Appareil d'impression sérigraphique

(30) Priorität: 14.02.1992 DE 4204390
(43) Veröffentlichungstag der Anmeldung: 18.08.1993
(73) Patentinhaber: Rheinmetall Industrie Aktiengesellschaft, 40880 Ratingen (DE)
(72) Erfinder: Sommer, Peter, W-4100 Duisburg 29 (DE)

(56) Entgegenhaltungen:
- PATENT ABSTRACTS OF JAPAN vol. 8, no. 238 (M-335)(1675) 31. Oktober 1984 & JP-A-59 118 460 ( MATSUSHITA DENKI SANGYO K.K. ) 9.Juli 1984

## Beschreibung

Die Erfindung betrifft einen Siebdruckvorrichtung nach dem Oberbegriff des Patentanspruchs 1.

Bei der Herstellung von Leiterkarten insbesondere aus niedrig sinternden ungebrannten Keramikfolien zum Herstellen von Mehrlagenschaltungen, vgl. J.I.Steinberg, S.J.Horowitz, R.J.Bacher, "Herstellen von Mehrlagenschaltungen mit niedrig sinternden grünen Keramikfolien", ELEKTRONIKPRODUKTION & Prüftechnik, Heft 9A (1986), werden die Leiterbahnenrohlinge in Form von ungebrannten Keramikfolien im Siebdruck mit Leiterpasten zum Erzeugen von Leiterbahnen bedruckt. Hierbei wird ein Siebdrucknest verwendet, das als Auflage für die grüne Keramikfolie dient und mit einer Vielzahl von kleinen Bohrungen versehen ist, um die grüne Keramikfolie durch Vakuum halten zu können. Hierbei dürfen die Bohrungen nicht zu groß sein, um zu vermeiden, daß sich das Muster der Bohrungen auf der Druckseite abzeichnet. Dementsprechend ist die Herstellung eines derartigen Siebdrucknestes sehr aufwendig. Wenn Durchkontaktierungen vorgesehen sind, bei denen sehr geringe Toleranzen einzuhalten sind, verschmutzt das darunter befindliche Bohrloch leicht.

Aufgabe der Erfindung ist es, eine Siebdruckvorrichtung nach dem Oberbegriff des Patentanspruchs 1 zu schaffen, die ein mit geringem Aufwand herstellbares Siebdrucknest aufweist.

Diese Aufgabe wird entsprechend dem kennzeichnenden Teil des Anspruchs 1 gelöst.

Der hier verwendete poröse, natürliche oder Kunststein, z.B. Bims, als Auflage für die Leiterkartenrohlinge, die gesintert oder ungesintert, sein können, ist wesentlich weniger aufwendig und damit wesentlich billiger in der Herstellung als ein Siebdrucknest mit einer großen Vielzahl von kleinen Bohrungen. Der poröse Stein bietet einen plane Auflage für die Leiterbahnrohlinge und eine einfache Beaufschlagung hiervon mit Vakuum, wobei das mit dem porösen Stein ausgerüstete Siebdrucknest unabhängig vom Design der Leiterbahnen bzw. der Durchkontaktierungen ist. Im Falle von Durchkontaktierungen wird der poröse Stein zweckmäßigerweise mit einer porösen Folie abgedeckt, damit keine Verschmutzungen beim Siebdrucken den porösen Stein unbrauchbar machen können.

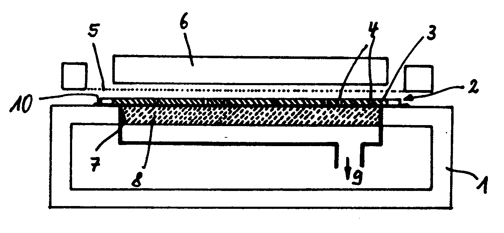

Die Erfindung wird nachstehend anhand eines in der beigefügten Abbildung schematisch dargestellten Ausführungsbeispiels näher erläutert.

Die dargestellte Siebdruckvorrichtung umfaßt eine Aufnahme 1 mit einem Siebdrucknest 2 für einen Leiterkartenrohling 3 beispielsweise in Form einer ungebrannten Keramikfolie mit Löchern 4 für Durchkontaktierungen. Über der Aufnahme 1 befindet sich ein Sieb 5 und ein Druckrakel 6 zum Drucken von Leiterbahnen aus einer entsprechenden Leiterpaste, etwa einer Silberlegierung.

Das Siebdrucknest 2 ist mit einer Ausnehmung 7 versehen, die einen an seiner zum Leiterkartenrohling 3 gewandten Seite plan geschliffenen, porösen Stein 8 bündig mit der Oberseite des Siebdrucknestes 2 aufnimmt. Der poröse Stein 8 ist auf dem Leiterkartenrohling 3 abgewandten Seite mit Vakuum 9 beaufschlagbar.

Über dem porösen Stein 8 ist eine poröse Folie 10 angeordnet, die die Vakuumbeaufschlagung des Leiterkartenrohlings 3 durch den porösen Stein 8 hindurch praktisch nicht behindert, aber ein Verschmutzen der Oberseite des porösen Steins 8 durch Leiterpaste, die beim Siebdruck in die Löcher 4 für die Durchkontaktierungen gelangt, verhindert.

## Patentansprüche

1. Siebdruckvorrichtung zum Bedrucken von Leiterkartenrohlingen (3) mit Leiterbahnen, wobei eine Siebdruckaufnahme (1) mit einem Siebdrucknest (2) für die Leiterkartenrohlinge (3) zur flächigen Unterstützung hiervon vorgesehen ist, wobei das Siebdrucknest (2) von der dem Leiterkartenrohling (3) abgewandten Seiten mit Vakuum (9) beaufschlagbar ist, dadurch **gekennzeichnet**, daß das Siebdrucknest (2) einen aus einem porösen Stein (8) gebildeten Einsatz aufweist, an den Vakuum (9) anlegbar ist.

2. Siebdruckvorrichtung zum Bedrucken von mit Durchkontaktierungen versehenen Leiterkartenrohlingen (3) mit Leiterbahnen nach Anspruch 1, dadurch gekennzeichnet, daß der poröse Stein (8) zum Leiterkartenrohling (3) hin mit einer porösen Folie (10) abgedeckt ist.

## Claims

1. Screen printing apparatus for printing circuit board blanks (3) with conductor tracks, the apparatus having a screen printing mounting (1) with a screen printing bed (2) for the circuit board blanks (3) and for full-surface support thereof, the screen printing bed (2) being subject to vacuum on the side facing away from the circuit board blank (3), characterised by the fact that the screen printing bed (2) has an insert which is formed from a porous stone material (8), to which vacuum (9) can be applied.

2. Screen printing apparatus for printing conductor tracks on circuit board blanks (3) provided with through-contacts, in accordance with Claim 1, characterised by the fact that the porous stone material (8) is covered on the side facing the circuit board blank (3) with a porous foil (10).

## Revendications

1. Dispositif d'impression sérigraphique destiné à imprimer des ébauches de cartes de circuits imprimés (3) avec des pistes conductrices, un logement pour sérigraphie (1) avec une empreinte sérigraphique pour les ébauches (3) étant prévu à cet effet afin de les soutenir à plat, l'empreinte (2) étant mise sous vide (9) à partir du côté tourné à l'opposé de l'ébauche (3), caractérisé en ce que l'empreinte (2) présente un insert formé d'une pierre poreuse (8), contre lequel s'applique le vide (9).

2. Dispositif d'impression sérigraphique destiné à imprimer des ébauches de cartes de circuits imprimés (3) pourvues de trous métallisés, avec des pistes conductrices selon la revendication 1, caractérisé en ce que la pierre poreuse (8) est recouverte vers l'ébauche (3) d'une feuille poreuse (10).
